# FASCICULE DE BREVET EUROPEEN

(11) **EP 3 379 269 B1**
(45) Date de publication et mention de la délivrance du brevet: **16.11.2022**
(21) Numéro de dépôt: 17162729.2
(22) Date de dépôt: 24.03.2017
(51) Int. Cl.: G01R 15/18, H02H 3/08

(54) **ACCESSOIRE DE CONTRÔLE POUR UN APPAREIL ÉLECTRIQUE POURVU D'UNE BORNE DE RACCORDEMENT**
KONTROLLZUBEHÖRTEIL FÜR EIN ELEKTRISCHES GERÄT, DAS MIT EINER ANSCHLUSSKLEMME AUSGESTATTET IST
MONITORING ACCESSORY FOR AN ELECTRICAL APPARATUS PROVIDED WITH A CONNECTION TERMINAL

(43) Date de publication de la demande: 26.09.2018
(73) Titulaire: TE Connectivity Solutions GmbH, 8200 Schaffhausen (CH)
(72) Inventeur: ESCOFFIER, Anna-Line, 69685 CHASSIEU (FR); VIRLOUVET, Annie, 69685 CHASSIEU (FR); PIONCHON, Laurence, 69685 CHASSIEU (FR)
(74) Mandataire: Germain Maureau

(56) Documents cités:
- WO-A1-02/08771
- DE-A1-102015 113 646
- US-A1- 2006 082 356
- US-A1- 2017 030 952

## Description

### Domaine de l'invention

La présente invention concerne un accessoire de contrôle pour un appareil électrique tel qu'un bloc de jonction.

### Art antérieur

Il est connu de s'assurer du bon fonctionnement d'un appareil électrique de type bloc de jonction en mesurant une température proche d'une borne de l'appareil électrique ou une intensité traversant un câble électrique raccordé à la borne.

Certains appareils électriques ou certains câbles électriques nécessitent une attention particulière car une intensité et/ou une température élevée peut signifier qu'une anomalie ou un dysfonctionnement est présent.

Des dispositifs de mesure de courants ou des dispositifs de mesure de températures sont connus et sont utilisés pour sécuriser une installation électrique ou simplement pour une maintenance préventive en vérifiant le bon état de fonctionnement d'appareils électriques.

Cependant comme ces dispositifs sont destinés à la fois à des installations existantes et des installations neuves, il peut s'avérer en pratique difficile d'installer de tels dispositifs rapidement et de manière fiables. Il peut en effet être nécessaire de procéder à une mise en place longue et fastidieuse.

La présente invention vise à résoudre tout ou partie des inconvénients mentionnés ci-dessus.

Des documents pertinents de l'art antérieure sont DE 10 2015 113646 A1, US 2006/082356 A1, US 2017/030952 A1 et WO 02/08771 A1.

### Exposé de l'invention

A cet effet, la présente invention concerne un accessoire de contrôle pour un appareil électrique pourvu d'une borne de raccordement apte à être raccordée à un câble électrique, l'accessoire de contrôle comprenant :
- un bâti pourvu d'un système de coopération configuré pour coopérer avec l'appareil électrique en une position montée, le système de coopération comprenant au moins un élément d'encliquetage configuré pour coopérer avec un élément complémentaire de l'appareil électrique en position montée,
- un capteur de courant agencé pour mesurer une intensité électrique traversant le câble électrique, lorsque le câble électrique est raccordé à la borne de raccordement, le capteur de courant comprenant une partie de mesure formant une boucle apte à entourer une section du câble électrique, la partie de mesure étant pourvue d'un système de fermeture apte maintenir la boucle en une position fermée et à ménager un espace de passage pour ladite section du câble électrique à l'intérieur de la boucle en position ouverte.

L'accessoire de contrôle est facile à mettre en place sur l'appareil électrique : il suffit de disposer le bâti sur l'appareil électrique et de disposer la boucle en position fermée une fois que la partie de mesure du capteur de courant est disposée autour du câble électrique.

Cette disposition permet d'éviter de détacher le câble électrique de la borne de l'appareil électrique pour la mise en place du capteur de courant.

Selon un aspect de l'invention, l'accessoire de contrôle comprend un capteur de température agencé pour mesurer une température à un emplacement déterminé par rapport à la borne de raccordement,

L'accessoire de contrôle est donc une solution de contrôle complète. La température et le courant sont mesurés pour détecter toute anomalie de fonctionnement. De plus l'installation de l'accessoire de contrôle est rapide et fiable, aucune manipulation du câble électrique n'étant nécessaire.Selon un aspect de l'invention, le système de coopération comprend au moins un élément d'accrochage apte à coopérer avec l'appareil électrique en une configuration accrochée dans laquelle l'accessoire de contrôle est apte à pivoter autour d'un axe d'accrochage de l'appareil électrique.

Cette disposition permet une mise en place aisée puisqu'il suffit de mettre en place l'élément d'accrochage puis de faire pivoter l'accessoire de contrôle pour l'installer sur l'appareil électrique.

De préférence, l'élément d'accrochage est configuré pour être accroché et décroché de l'appareil électrique par déformation élastique.

Selon un aspect de l'invention, le système de coopération comprend au mois un élément d'encliquetage configuré pour coopérer avec un élément complémentaire de l'appareil électrique en position montée.

Cette disposition permet une mise en place et un retrait aisés de l'accessoire de contrôle ne nécessitant pas d'outil.

Selon un aspect de l'invention, le système de coopération comprend deux éléments d'accrochage et/ou deux éléments d'encliquetage.

Cette disposition permet de réaliser un bon centrage du bâti par rapport à l'appareil électrique lors de la mise en place de l'accessoire de contrôle sur l'appareil électrique.

Selon un aspect de l'invention, le bâti comprend une paroi externe dans laquelle est ménagé un enfoncement d'accueil pour le câble électrique, lorsque le câble électrique est raccordé à la borne de raccordement.

Cette disposition permet d'une part l'installation de l'accessoire de contrôle sans avoir à débrancher le câble électrique et d'autre part de guider la portion du câble électrique entre la borne et l'extérieur du bâti.

Il est ainsi plus aisé de mettre en place le capteur de courant car la position de la portion du câble électrique sortant du bâti est connue.

Selon un aspect de l'invention, l'accessoire de contrôle comprend une unité de contrôle pourvue d'un processeur, l'unité de contrôle étant apte à obtenir des valeurs mesurées en provenance du capteur de température et/ou du capteur de courant.

Cette disposition permet un traitement local des valeurs mesurées par l'utilisation d'un processeur ou microcontrôleur. Il est donc possible de prévoir un fonctionnement autonome de l'accessoire contrôle.

Selon un aspect de l'invention, le bâti présente un logement interne dans lequel est disposée l'unité de contrôle, le bâti comprenant une portion de fermeture dudit logement interne.

Cette disposition permet de mettre en place l'unité de contrôle lors de la fabrication et également de protéger l'unité de traitement lors de l'utilisation de l'accessoire de contrôle.

Selon un aspect de l'invention, la partie de mesure du capteur de courant comprend un enroulement de Rogowski.

Cette disposition améliore encore la rapidité et la fiabilité d'installation puisqu'un enroulement de Rogowski présente une certaine souplesse permettant de le déformer lors de l'installation ou du retrait de l'accessoire de contrôle.

Selon un aspect de l'invention, l'accessoire de contrôle comprend un élément de liaison de la partie de mesure du capteur de courant avec le bâti, l'élément de liaison étant configuré pour autoriser un déplacement de la partie de mesure par rapport au bâti.

De préférence, ledit déplacement est défini dans une limite déterminée. En particulier la limite déterminée dépend d'une longueur de l'élément de liaison.

Cette disposition permet une mise en place simple de l'accessoire de contrôle en deux temps.

Tout d'abord le bâti est raccordé à l'appareil électrique sans avoir à détacher le câble électrique. La partie de mesure se déplace par rapport au bâti grâce à l'élément de liaison ce qui permet une mise en place rapide.

Ensuite, une fois que le bâti coopère avec l'appareil électrique, la partie de mesure peut être déplacée, séparée en deux au niveau des attaches de fermeture puis installée autour de la section correspondante du câble électrique.

Selon un aspect de l'invention, l'accessoire de contrôle comprend une prise d'alimentation électrique ou une batterie interne.

Cette disposition permet le fonctionnement du capteur de température et du capteur de courant. Selon un aspect de l'invention la prise d'alimentation est une prise pour une alimentation 24V, 110 V ou 230 V.

Ainsi, lorsque l'appareil électrique est installé dans un coffret électrique il est possible d'utiliser l'alimentation disponible dans ce coffret électrique pour l'alimentation de l'accessoire de contrôle.

Lorsqu'une batterie interne est utilisée, l'accessoire de contrôle est totalement indépendant.

Selon un aspect de l'invention, l'accessoire de contrôle comprend un avertisseur agencé pour être déclenché lorsqu'au moins une valeur mesurée par le capteur de température et/ou le capteur de courant dépasse une valeur limite correspondante.

Cette disposition permet de prévenir un utilisateur qu'un dysfonctionnement ou une anomalie a été détectée par l'accessoire de contrôle.

Selon un aspect de l'invention, l'avertisseur comprend un écran d'affichage apte à afficher au moins une valeur mesurée par le capteur de température ou le capteur de courant.

Selon un aspect de l'invention, l'avertisseur comprend un élément lumineux disposé sur ou ménagé dans le bâti.

Cette disposition permet d'alerter visuellement l'utilisateur, par exemple par une lumière rouge qui peut optionnellement être clignotante.

Selon un aspect de l'invention l'élément lumineux comprend au moins une diode électroluminescente.

Selon un aspect de l'invention, l'accessoire de contrôle comprend un élément de communication configuré pour transmettre des informations à destination d'un dispositif récepteur distant.

Cette disposition permet en outre de communiquer vers le dispositif récepteur toute anomalie ou dysfonctionnement détecté par l'accessoire de contrôle.

Selon un aspect de l'invention, une information à destination du dispositif récepteur distant comprend au moins une valeur mesurée en provenance du capteur de courant et/ou du capteur de température.

Selon un aspect de l'invention, l'élément de communication comprend une prise de raccordement à un câble de liaison au dispositif récepteur distant.

Cette disposition permet de réaliser une transmission filaire d'informations en provenance de l'accessoire de commande. Lorsque l'accessoire de commande est dans un coffret électrique formant une cage de Faraday, le raccordement filaire permet de communiquer avec l'extérieur de coffret, un câble de communication raccordé à la prise sortant du coffret par une ouverture dédiée.

Lorsqu'un coffret comprend plusieurs accessoires de contrôle, les accessoires de contrôles peuvent être reliés entre aux par l'intermédiaire des prises de raccordement puis ils peuvent être reliés au dispositif récepteur.

Selon un aspect de l'invention, l'élément de communication comprend un émetteur configuré pour transmettre des informations selon un protocole de communication sans fil.

Cette disposition permet d'obtenir un retour de l'accessoire de contrôle sans être raccordé par une connexion filaire. La surveillance est ainsi facilitée : l'utilisateur n'a pas à se trouver à proximité de l'accessoire pour être informé d'une anomalie ou d'un dysfonctionnement.

Selon un aspect de l'invention l'élément de communication comprend en outre un récepteur configuré pour recevoir des informations selon le protocole de communication sans fil.

Cette disposition est intéressante lorsque plusieurs accessoires de contrôle sont disposés dans un même coffret. Seul un des accessoires de contrôle peut comprendre un récepteur pour recevoir les informations en provenance des autres accessoires de contrôle.

Les informations ainsi centralisées peuvent ensuite être transmises au dispositif récepteur par exemple par la prise de raccordement.

La présente invention concerne également un ensemble électrique comprenant un appareil électrique pourvu d'une borne de raccordement à un câble électrique et un accessoire de contrôle tel que décrit ci-avant, l'accessoire de contrôle comprenant un bâti pourvu d'un système de coopération configuré pour coopérer avec l'appareil électrique en une position montée.

Selon un aspect de l'invention, l'appareil électrique est un bloc de jonction.

Selon un aspect de l'invention, le bloc de jonction est un bloc de distribution c'est-à-dire un bloc comprenant une borne d'entrée et au moins deux bornes de sorties.

Selon un aspect de l'invention, lorsque l'accessoire de contrôle comprend un élément de communication, l'ensemble électrique comprend un dispositif récepteur apte à recevoir des informations en provenance l'accessoire de contrôle.

De préférence, le dispositif récepteur est agencé pour être ménagé dans un coffret électrique. Le dispositif récepteur comprend un élément de transfert d'informations externe, ledit élément étant configuré pour être disposé à l'extérieur du coffret.

Cette disposition permet de regrouper au niveau du dispositif récepteur les informations en provenance du ou des accessoires de contrôle situés dans le coffret et de transférer ces informations vers un réseau étendu par exemple Internet par l'utilisation d'un module sans fil compris dans l'élément de transfert.

Selon les variantes de réalisation, il est possible de définir une communication entre les accessoires de contrôle qui est de type filaire ou sans fil ou partiellement filaire et sans fil.

De manière analogue, le dispositif récepteur peut être raccordé aux accessoires de contrôle par une connexion filaire ou sans fil. Egalement, le dispositif récepteur peut être raccordé au réseau étendu par une connexion filaire ou sans fil. Toutes les combinaisons de types de connexions sont envisageables.

La présente invention concerne en outre un procédé de surveillance d'un appareil électrique par un accessoire de contrôle tel que décrit ci-avant, l'appareil électrique étant pourvu d'une borne de raccordement raccordée à un câble électrique, le procédé de surveillance comprenant les étapes suivantes :
- mesurer une intensité électrique traversant le câble électrique et obtenir une valeur mesurée de l'intensité électrique,
- comparer la valeur mesurée de l'intensité électrique à une valeur limite d'intensité électrique,
- établir une information d'avertissement de dépassement de valeur limite de l'intensité électrique lorsque valeur mesurée de l'intensité électrique est supérieure à la valeur limite d'intensité électrique,

Cette disposition permet de relever de manière systématique toute valeur mesurée pouvant être considérée comme se reportant à une anomalie ou un dysfonctionnement.

Selon un aspect de l'invention, le procédé de surveillance d'un appareil électrique comprend en outre les étapes suivantes :
- mesurer une température à un emplacement déterminé par rapport à la borne de raccordement (4) et obtenir une valeur mesurée de la température,
- comparer la valeur mesurée de la température à une valeur limite de température,
- établir une information d'avertissement de dépassement de la valeur limite de température lorsque la valeur mesurée de l'intensité électrique est supérieure à la valeur limite d'intensité électrique.

Selon un aspect de l'invention, lorsque une pluralité d'informations d'avertissement de dépassement de valeur limite d'intensité électrique ou de température sont établies, une étape consiste à établir au moins une information d'alerte définissant un type de dysfonctionnement ou d'anomalie.

Ainsi, les valeurs de températures et d'intensités électriques mesures sont considérées en même temps pour déterminer le type de dysfonctionnement ou d'anomalie.

Les différents aspects définis ci-dessus non incompatibles peuvent être combinés.

### Brève description des figures

L'invention sera mieux comprise à l'aide de la description détaillée qui est exposée ci-dessous en regard du dessin annexé dans lequel :
- la figure 1 est une vue en perspective d'un ensemble électrique comprenant un appareil électrique et un accessoire de contrôle ;
- la figure 2 est une vue de face de l'ensemble électrique ;
- la figure 3 est une vue de côté de l'ensemble électrique ;
- la figure 4 est une vue de dessus de l'ensemble électrique ;
- la figure 5 est une vue schématique d'un coffret électrique dans lequel est disposé une pluralité d'ensembles électriques ;
- la figure 6 est un schéma des étapes d'un procédé de surveillance de l'appareil électrique.

### Description en référence aux figures

Dans la description détaillée qui va suivre des figures définies ci-dessus, les mêmes éléments ou les éléments remplissant des fonctions identiques pourront conserver les mêmes références de manière à simplifier la compréhension de l'invention.

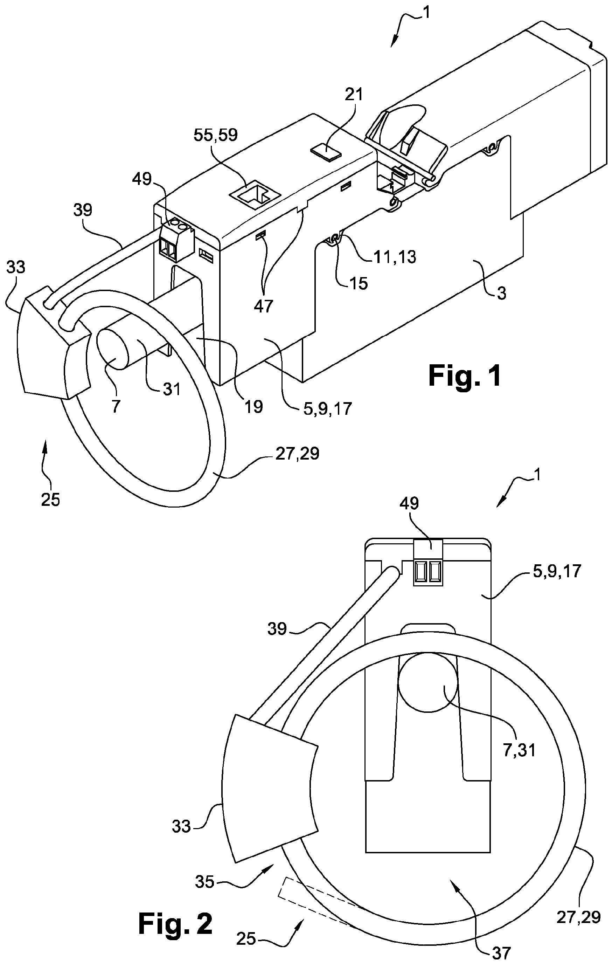

Comme illustré à la figure 1, un ensemble électrique 1 comprend un appareil électrique 3 et un accessoire de contrôle 5.

Dans le mode de réalisation présenté, l'appareil électrique 3 est un bloc de jonction comprenant une borne de raccordement 4 à laquelle est raccordé un câble électrique 7 de puissance. Selon une variante non représenté le bloc de jonction peut être un bloc de distribution.

L'accessoire de contrôle 5 comprend un bâti 9 pourvu d'un système de coopération 11 configuré pour coopérer avec l'appareil électrique 3 en une position montée comme représentée dans les figures 1 à 5.

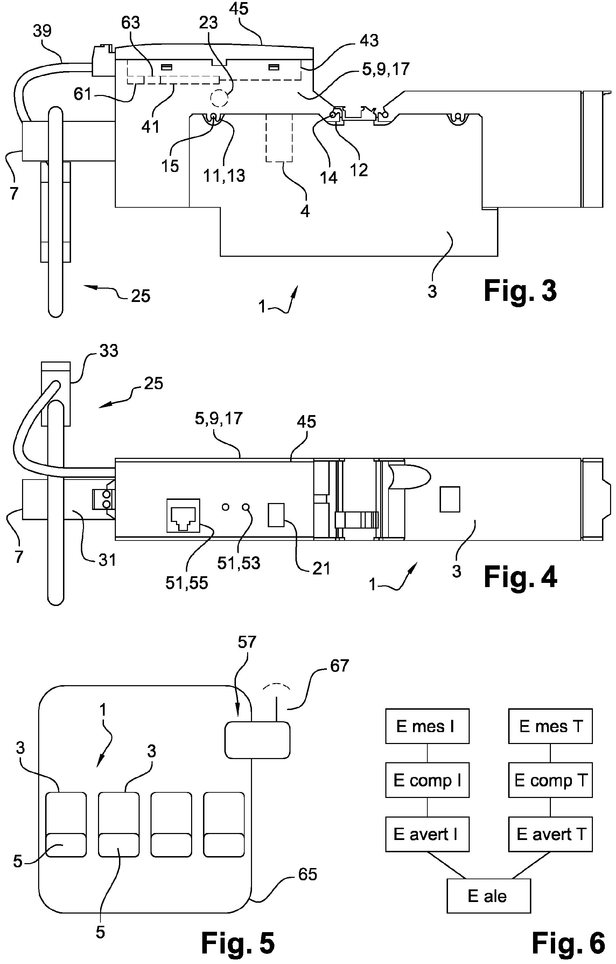

Le système de coopération 11 comprend deux éléments d'accrochage 12 disposés de chaque côté du bâti 9 aptes à coopérer avec l'appareil électrique 3 en une configuration accrochée dans laquelle l'accessoire de contrôle 5 est apte à pivoter autour d'un axe d'accrochage 14 de l'appareil électrique 3 comme illustré à la figure 3.

Les éléments d'accrochage 12 sont configurés pour être accrochés et décrochés de l'appareil électrique 3 par déformation élastique. Le système de coopération 11 comprend deux éléments d'encliquetage 13 disposés de chaque côté du bâti 9, chacun étant agencé pour coopérer avec un élément complémentaire 15 de l'appareil électrique 3 en position montée. Le bâti 9 peut ainsi être désolidarisé de l'appareil électrique 3 sans utilisation d'outil.

Le bâti 9 comprend une paroi externe 17 dans laquelle est ménagé un enfoncement d'accueil 19 pour le câble électrique 7 permettant de guider une portion extrême du câble électrique 7 raccordée à la borne de raccordement 4.

Le bâti 9 comprend une étiquette d'identification 21 permettant de référencer l'accessoire de contrôle 5.

L'accessoire de contrôle 5 comprend un capteur de température 23 agencé pour mesurer une température à un emplacement déterminé par rapport à la borne de raccordement 4 de l'appareil électrique 3.

Ainsi la température mesurée par le capteur de température 23 dépend directement de la température au niveau de la borne de raccordement 4.

L'accessoire de contrôle 5 comprend également un capteur de courant 25 configuré pour mesurer un courant traversant le câble électrique 7 lorsque le câble électrique 7 est raccordé à la borne de raccordement 4 comme illustré aux figures 1 à 4.

Le capteur de courant 25 est de type Rogowski, c'est-à-dire qu'il comprend un enroulement de Rogowski 27 entourant le câble électrique 7.

L'enroulement de Rogowski 27 est compris dans une partie de mesure 29 du capteur de courant 25 formant une boucle.

Comme illustré aux figures 1 à 4, la partie de mesure 29 entoure une section 31 du câble électrique 7, ce qui permet de mesurer une intensité traversant le câble électrique 7.

La partie de mesure 29 comprend un système de fermeture 33 agencé pour maintenir la boucle formée par la partie de mesure 29 en une position fermée comme illustré aux figures 1 à 4.

Le système de fermeture 33 est également configuré pour être disposé en une position ouverte dans laquelle est ménagé un espace de passage 35 à l'intérieur de la boucle pour le câble électrique 7.

Il s'agit d'engendrer une ouverture dans la boucle en la désolidarisant au niveau du système de fermeture 33 pour que le câble électrique 7 entre ou sorte de l'intérieur 37 de la boucle sans avoir à détacher le câble électrique 7 de la borne de raccordement 4.

L'accessoire de contrôle 5 comprend également un élément de liaison 39 de la partie de mesure 29 au bâti 9. Cet élément de liaison 39 présente une certaine souplesse autorisant un déplacement de la partie de mesure 29 par rapport au bâti 9 dans une limite déterminée fonction de la longueur de l'élément de liaison 39.

Comme illustré à la figure 3, l'accessoire de contrôle 5 comprend également une unité de contrôle 41 pourvue d'un processeur. L'unité de contrôle 41 est disposée dans un logement interne 43 de l'accessoire de contrôle 5, la paroi externe 17 du bâti 9 étant pourvue d'une portion de fermeture 45 dudit logement interne 43.

L'accessoire de contrôle 5 est pourvu d'un élément de fixation 47 pour maintenir une coopération entre la portion de fermeture 45 et le reste du bâti 9. Dans le mode de réalisation présenté, l'élément de fixation 47 comprend un système d'encliquetage. Selon une autre variante non représentée, l'élément de fixation 47 peut comprendre une vis.

L'unité de contrôle 41 est configurée pour obtenir des valeurs mesurées en provenance du capteur de température 23 et du capteur de courant 25. Le processeur est ainsi apte à enregistrer les valeurs mesurées et les comparer à des valeurs limites préalablement définies en mémoire du processeur. Une information d'avertissement de dépassement de la valeur limite d'intensité ou de température est élaborée par le processeur en cas de dépassement.

Ainsi, comme illustré à la figure 6, un procédé de surveillance de l'appareil électrique 3 comprend les étapes consistant à :
- mesurer E mes I une intensité électrique traversant le câble électrique 7 et obtenir une valeur mesurée de l'intensité électrique,
- comparer E comp I la valeur mesurée de l'intensité électrique à une valeur limite d'intensité électrique,
- établir E avert I une information d'avertissement de dépassement de valeur limite de l'intensité électrique lorsque valeur mesurée de l'intensité électrique est supérieure à la valeur limite d'intensité électrique.

Les mêmes étapes de mesure E mes T, de comparaison E comp T et d'établissement d'une information d'avertissement de dépassement de valeur limite de température E avert T sont réalisées parallèlement.

Le processeur est apte à traiter les informations d'avertissement de dépassement de valeur limite selon leurs intensités et leurs fréquences de répétition, pour établir des informations d'alerte E ale définissant un type de dysfonctionnement ou d'anomalie.

Pour son alimentation, l'accessoire de contrôle 5 comprend une prise d'alimentation 49 de type alimentation 24V. Selon une variante non représentée, l'accessoire de contrôle 5 peut comprendre une batterie pour son alimentation.

L'accessoire de contrôle 5 comprend en outre un avertisseur 51 agencé pour être déclenché et avertir un utilisateur lorsque le capteur de température 23 ou le capteur de courant 25 mesure une valeur au-delà d'une valeur limite correspondante.

L'avertisseur 51 comprend un élément lumineux 53 ménagé dans le bâti 9 et agencé pour émettre une lumière particulière pour signaler un dépassement de valeur limite, par exemple une lumière rouge clignotante.

Dans le mode de réalisation présenté, l'avertisseur comprend deux diodes électroluminescentes.

Selon une variante non représentée, l'avertisseur 51 peut comprendre un écran d'affichage configuré pour afficher des valeurs mesurées, par exemple des valeurs instantanées.

L'accessoire de contrôle 5 comprend également un élément de communication 55 apte à envoyer des informations d'alerte ou d'avertissement de dépassement de valeur limite d'intensité électrique ou de température à un dispositif récepteur 57 comme illustré à la figure 5.

L'élément de communication 55 comprend une prise de raccordement 59 à un câble de liaison au dispositif récepteur 57 ou à un autre accessoire de contrôle 5.

L'élément de communication 55 peut comprendre également ou en remplacement de la prise de raccordement 59 un émetteur 61 et un récepteur 63 configurés pour échanger des informations selon un protocole de communication sans fil comme le Bluetooth.

Comme illustré à la figure 5, l'ensemble électrique 1 peut comprendre une pluralité d'appareils électriques 3 et d'accessoires de contrôle 5 disposés à l'intérieur d'un coffret électrique 65. Le dispositif récepteur 57 est également ménagé dans le coffret électrique 65.

Le coffret électrique 65 de par sa constitution engendre une cage de faraday empêchant l'échange d'informations selon le protocole de communication sans fil entre l'intérieur et l'extérieur du coffret électrique 65.

Avec l'ensemble électrique 1 présenté ci-avant plusieurs possibilités existent pour transmettre les informations relatives aux mesures des capteurs 23, 25 vers un réseau étendu de type Internet via le dispositif récepteur 57.

Une possibilité consiste à raccorder les accessoires de contrôles 5 présents dans le coffret électrique 65 par des câbles de liaison. Un des accessoires de contrôle 5 est raccordé par un câble de liaison au dispositif récepteur 57 pour centraliser les informations en provenance de tous les accessoires de contrôle 5.

Comme illustré à la figure 5, le dispositif récepteur 57 comprend un élément de transfert d'informations externe 67. Ledit élément 67 comprend un module sans fil étant disposé à l'extérieur du coffret électrique 65 qui est ainsi apte à communiquer par exemple en utilisant un réseau Wifi local.

Cette disposition permet de regrouper au niveau du dispositif récepteur 57 les informations en provenance des accessoires de contrôle situés dans le coffret électrique 65 et de transférer ces informations vers le réseau étendu.

Une autre possibilité consiste à lier les accessoires de contrôles 5 par des câbles de liaison, un des accessoires de contrôle 5 comprenant un émetteur 61 et un récepteur 63 aptes à communiquer avec le dispositif récepteur 57 et les autres accessoires de contrôle 5 à l'intérieur du coffret électrique 65.

Une autre possibilité consiste à équiper chaque accessoire de contrôle 5 d'un émetteur 61 et d'un récepteur 63 pour que les informations remontent au dispositif récepteur 57 à l'intérieur du coffret électrique 65.

Le dispositif récepteur 57 sert ainsi de passerelle pour communiquer les informations de mesure vers l'extérieur pour s'affranchir du problème lié à la cage de Faraday engendrée par le coffret électrique 65.

L'utilisation d'accessoire de contrôle 5 présente plusieurs avantages.

La mise en place de l'accessoire de contrôle 5 sur l'appareil électrique 3 est aisée puisqu'il suffit d'encliqueter le bâti 9 et ensuite d'ouvrir la boucle du capteur de courant 25 pour la refermer autour du câble électrique 7. La souplesse de l'élément de liaison 39 ne gêne pas lors de l'encliquetage.

Le fait de disposer d'un avertisseur 51 à la fois visuel et communiquant permet de transmettre toute anomalie ou dysfonctionnement à un utilisateur en utilisant un réseau local comme le Bluetooth ou le Wifi.

La surveillance permise par l'accessoire de contrôle 5 est donc complète : l'accessoire de contrôle convient donc aux installations électriques neuves ou aux installations électriques existantes.

Comme il va de soi, l'invention ne se limite pas à la seule forme d'exécution décrite ci-dessus à titre d'exemple, elle en embrasse au contraire toutes les variantes de réalisation, telles que définies par les revendications annexées.

## Revendications

1. Accessoire de contrôle (5) pour un appareil électrique (3) pourvu d'une borne de raccordement (4) apte à être raccordée à un câble électrique (7), l'accessoire de contrôle (5) comprenant :
- un bâti (9) pourvu d'un système de coopération (11) configuré pour coopérer avec l'appareil électrique (3) en une position montée, le système de coopération (11) comprenant au moins un élément d'encliquetage configuré pour coopérer avec un élément complémentaire de l'appareil électrique (3) en position montée,
- un capteur de courant (25) agencé pour mesurer une intensité électrique traversant le câble électrique (7), lorsque le câble électrique (7) est raccordé à la borne de raccordement (4), le capteur de courant (25) comprenant une partie de mesure (29) formant une boucle apte à entourer une section (31) du câble électrique (7), la partie de mesure (29) étant pourvue d'un système de fermeture (33) apte à maintenir la boucle en une position fermée et à ménager un espace de passage (35) pour ladite section (31) du câble électrique (7) à l'intérieur de la boucle en position ouverte.

2. Accessoire de contrôle (5) selon la revendication 1, comprenant un capteur de température (23) agencé pour mesurer une température à un emplacement déterminé par rapport à la borne de raccordement (4).

3. Accessoire de contrôle (5) selon l'une des revendications 1 ou 2, comprenant une unité de contrôle (41) pourvue d'un processeur, l'unité de contrôle (41) étant apte à obtenir des valeurs mesurées en provenance du capteur de température (23) et/ou du capteur de courant (25).

4. Accessoire de contrôle (5) selon la revendication 3, dans lequel le bâti (9) présente un logement interne (43) dans lequel est disposée l'unité de contrôle (41), le bâti (9) comprenant une portion de fermeture (45) dudit logement interne (43).

5. Accessoire de contrôle (5) selon l'une des revendications 1 à 4, dans lequel la partie de mesure (29) du capteur de courant (25) comprend un enroulement de Rogowski (27).

6. Accessoire de contrôle (5) selon l'une des revendications 1 à 5, comprenant un élément de liaison (39) de la partie de mesure (29) du capteur de courant (25) avec le bâti (9), l'élément de liaison (39) étant configuré pour autoriser un déplacement de la partie de mesure (29) par rapport au bâti (9).

7. Accessoire de contrôle (5) selon l'une des revendications 1 à 6, comprenant un avertisseur (51) agencé pour être déclenché lorsqu'au moins une valeur mesurée par le capteur de température (23) et/ou le capteur de courant (25) dépasse une valeur limite correspondante.

8. Accessoire de contrôle (5) selon la revendication 7, dans lequel l'avertisseur (51) comprend un élément lumineux (53) disposé sur ou ménagé dans le bâti (9).

9. Accessoire de contrôle (5) selon l'une des revendications 1 à 8, comprenant un élément de communication (55) configuré pour transmettre des informations à destination d'un dispositif récepteur (57) distant.

10. Accessoire de contrôle (5) selon la revendication 9, dans lequel l'élément de communication (55) comprend une prise de raccordement (59) à un câble de liaison au dispositif récepteur (57) distant.

11. Accessoire de contrôle (5) selon l'une des revendications 9 ou 10, dans lequel l'élément de communication (55) comprend un émetteur (61) configuré pour transmettre des informations selon un protocole de communication sans fil.

12. Accessoire de contrôle (5) selon la revendication 11, dans lequel l'élément de communication (55) comprend en outre un récepteur (63) configuré pour recevoir des informations selon le protocole de communication sans fil.

13. Ensemble électrique (1) comprenant un appareil électrique (3) pourvu d'une borne de raccordement (4) à un câble électrique (7) et un accessoire de contrôle (5) selon l'une des revendications 1 à 12, l'accessoire de contrôle (5) comprenant un bâti (9) pourvu d'un système de coopération (11) configuré pour coopérer avec l'appareil électrique (3) en une position montée.

14. Procédé de surveillance d'un appareil électrique (3) par un accessoire de contrôle (5) selon l'une des revendications 1 à 12, l'appareil électrique (3) étant pourvu d'une borne de raccordement (4) raccordée à un câble électrique (7), le procédé de surveillance comprenant les étapes suivantes :
- (E mes I) mesurer une intensité électrique traversant le câble électrique (7) et obtenir une valeur mesurée de l'intensité électrique,
- (E comp I) comparer la valeur mesurée de l'intensité électrique à une valeur limite d'intensité électrique,
- (E avert I) établir une information d'avertissement de dépassement de valeur limite de l'intensité électrique lorsque valeur mesurée de l'intensité électrique est supérieure à la valeur limite d'intensité électrique.

15. Procédé de surveillance d'un appareil électrique (3) selon la revendication 14, comprenant en outre les étapes suivantes :
- (E mes T) mesurer une température à un emplacement déterminé par rapport à la borne de raccordement (4) et obtenir une valeur mesurée de la température,
- (E comp T) comparer la valeur mesurée de la température à une valeur limite de température,
- (E avert T) établir une information d'avertissement de dépassement de la valeur limite de température lorsque la valeur mesurée de l'intensité électrique est supérieure à la valeur limite d'intensité électrique.

## Patentansprüche

1. Kontrollzubehörteil (5) für ein elektrisches Gerät (3), das mit einer Anschlussklemme (4) ausgestattet ist, geeignet, um mit einem elektrischen Kabel (7) verbunden zu werden, wobei das Kontrollzubehörteil (5) umfasst:
- ein Gehäuse (9), das mit einem Kooperationssystem (11) ausgestattet ist, konfiguriert, um mit dem elektrischen Gerät (3) in einer fixierten Position zu kooperieren, wobei das Kooperationssystem (11) mindestens ein Einrastelement umfasst, konfiguriert, um mit einem ergänzenden Element des elektrischen Geräts (3) in der fixierten Position zu kooperieren,
- einen Stromsensor (25), der zum Messen einer elektrischen Stromstärke, die das elektrische Kabel (7) durchfließt, eingerichtet ist, wenn das elektrische Kabel (7) mit der Anschlussklemme (4) verbunden ist, wobei der Stromsensor (25) ein Messteil (29) umfasst, das einen Ring bildet, geeignet, um einen Bereich (31) des elektrischen Kabels (7) zu umgeben, wobei das Messteil (29) mit einem Verschlusssystem (33) ausgestattet ist, geeignet, um den Ring in einer geschlossenen Position zu halten und einen Durchgangsraum (35) für den Bereich (31) des elektrischen Kabels (7) innerhalb des Rings in offener Position unterzubringen.

2. Kontrollzubehörteil (5) nach Anspruch 1, einen Temperatursensor (23) umfassend, der zum Messen einer Temperatur an einer bestimmten Stelle relativ zur Anschlussklemme (4) eingerichtet ist.

3. Kontrollzubehörteil (5) nach einem der Ansprüche 1 oder 2, eine Kontrolleinheit (41) umfassend, die mit einem Prozessor ausgestattet ist, wobei die Kontrolleinheit (41) geeignet ist, um gemessene Werte zu erhalten, die vom Temperatursensor (23) und/oder dem Stromsensor (25) stammen.

4. Kontrollzubehörteil (5) nach Anspruch 3, wobei das Gehäuse (9) eine innere Aufnahme (43) aufweist, in der die Kontrolleinheit (41) angeordnet ist, wobei das Gehäuse (9) einen Verschlussabschnitt (45) der inneren Aufnahme (43) umfasst.

5. Kontrollzubehörteil (5) nach einem der Ansprüche 1 bis 4, wobei das Messteil (29) des Stromsensors (25) eine Rogowskispule (27) umfasst.

6. Kontrollzubehörteil (5) nach einem der Ansprüche 1 bis 5, ein Verbindungselement (39) des Messteils (29) des Stromsensors (25) mit dem Gehäuse (9) umfassend, wobei das Verbindungselement (39) konfiguriert ist, um eine Verschiebung des Messteils (29) relativ zum Gehäuse (9) zuzulassen.

7. Kontrollzubehörteil (5) nach einem der Ansprüche 1 bis 6, einen Warner (51) umfassend, eingerichtet, um auszulösen, wenn mindestens ein vom Temperatursensor (23) und/oder dem Stromsensor (25) gemessener Wert einen entsprechenden Grenzwert überschreitet.

8. Kontrollzubehörteil (5) nach Anspruch 7, wobei der Warner (51) ein Leuchtelement (53) umfasst, das auf dem Gehäuse (9) angeordnet oder darin untergebracht ist.

9. Kontrollzubehörteil (5) nach einem der Ansprüche 1 bis 8, ein Kommunikationselement (55) umfassend, konfiguriert, um Informationen an eine entfernte Empfangsvorrichtung (57) zu übertragen.

10. Kontrollzubehörteil (5) nach Anspruch 9, wobei das Kommunikationselement (55) eine Anschlussbuchse (59) für ein Verbindungskabel zur entfernten Empfangsvorrichtung (57) umfasst.

11. Kontrollzubehörteil (5) nach einem der Ansprüche 9 oder 10, wobei das Kommunikationselement (55) einen Sender (61) umfasst, konfiguriert, um Informationen gemäß einem drahtlosen Kommunikationsprotokoll zu übertragen.

12. Kontrollzubehörteil (5) nach Anspruch 11, wobei das Kommunikationselement (55) ferner einen Empfänger (63) umfasst, konfiguriert, um Informationen gemäß dem drahtlosen Kommunikationsprotokoll zu empfangen.

13. Elektrische Einheit (1), ein elektrisches Gerät (3) umfassend, das mit einer Anschlussklemme (4) für ein elektrisches Kabel (7) und einem Kontrollzubehörteil (5) ausgestattet ist, nach einem der Ansprüche 1 bis 12, wobei das Kontrollzubehörteil (5) ein Gehäuse (9) umfasst, das mit einem Kooperationssystem (11) ausgestattet ist, konfiguriert, um mit dem elektrischen Gerät (3) in einer fixierten Position zu kooperieren.

14. Verfahren zur Überwachung eines elektrischen Geräts (3) durch ein Kontrollzubehörteil (5) nach einem der Ansprüche 1 bis 12, wobei das elektrische Gerät (3) mit einer Anschlussklemme (4) ausgestattet ist, die mit einem elektrischen Kabel (7) verbunden ist, wobei das Überwachungsverfahren die folgenden Schritte umfasst:
- (E mes I) Messen einer elektrischen Stromstärke, die das elektrische Kabel (7) durchfließt und Erhalten eines gemessenen Wertes der elektrischen Stromstärke,
- (E comp I) Vergleichen des gemessenen Wertes der elektrischen Stromstärke mit einem Grenzwert der elektrischen Stromstärke,
- (E avert I) Erstellen einer Warninformation der Überschreitung des Grenzwertes der elektrischen Stromstärke, wenn der gemessene Wert der elektrischen Stromstärke über dem Grenzwert der elektrischen Stromstärke liegt.

15. Verfahren zur Überwachung eines elektrischen Geräts (3) nach Anspruch 14, ferner die folgenden Schritte umfassend:
- (E mes T) Messen einer Temperatur an einer bestimmten Stelle relativ zur Anschlussklemme (4) und Erhalten eines gemessenen Wertes der Temperatur,
- (E comp T) Vergleichen des gemessenen Wertes der Temperatur mit einem Grenzwert der Temperatur,
- (E avert T) Erstellen einer Warninformation der Überschreitung des Grenzwertes der Temperatur, wenn der gemessene Wert der elektrischen Stromstärke über dem Grenzwert der elektrischen Stromstärke liegt.

## Claims

1. A control accessory (5) for an electrical apparatus (3) provided with a connection terminal (4) capable of being connected to an electric cable (7), the control accessory (5) comprising:
- a frame (9) provided with a cooperation system (11) configured to cooperate with the electrical apparatus (3) in a mounted position, the cooperation system (11) comprising at least one snap-fitting element configured to cooperate with a complementary element of the electrical apparatus (3) in the mounted position,
- a current sensor (25) arranged to measure an electrical current flowing through the electric cable (7), when the electric cable (7) is connected to the connection terminal (4), the current sensor (25) comprising a measuring portion (29) forming a loop capable of surrounding a section (31) of the electric cable (7), the measuring portion (29) being provided with a closing system (33) capable of maintaining the loop in a closed position and providing a passage space (35) for said section (31) of the electric cable (7) inside the loop in the open position.

2. The control accessory (5) according to claim 1, comprising a temperature sensor (23) arranged to measure a temperature at a determined location relative to the connection terminal (4).

3. The control accessory (5) according to any of claims 1 or 2, comprising a control unit (41) provided with a processor, the control unit (41) being capable of obtaining measured values from the temperature sensor (23) and/or the current sensor (25).

4. The control accessory (5) according to claim 3, wherein the frame (9) has an internal housing (43) in which the control unit (41) is disposed, the frame (9) comprising a portion (45) for closing said internal housing (43).

5. The control accessory (5) according to any of claims 1 to 4, wherein the measuring portion (29) of the current sensor (25) comprises a Rogowski coil (27).

6. The control accessory (5) according to any of claims 1 to 5, comprising an element (39) for linking the measuring portion (29) of the current sensor (25) with the frame (9), the linking element (39) being configured to allow movement of the measuring portion (29) relative to the frame (9).

7. The control accessory (5) according to any of claims 1 to 6, comprising a warning device (51) arranged to be triggered when at least one value measured by the temperature sensor (23) and/or the current sensor (25) exceeds a corresponding limit value.

8. The control accessory (5) according to claim 7, wherein the warning device (51) comprises a luminous element (53) disposed on or formed in the frame (9).

9. The control accessory (5) according to any of claims 1 to 8, comprising a communication element (55) configured to transmit information to a remote receiver device (57).

10. The control accessory (5) according to claim 9, wherein the communication element (55) comprises a socket (59) for connection to a cable for linkage to the remote receiver device (57).

11. The control accessory (5) according to any of claims 9 or 10, wherein the communication element (55) comprises a transmitter (61) configured to transmit information according to a wireless communication protocol.

12. The control accessory (5) according to claim 11, wherein the communication element (55) further comprises a receiver (63) configured to receive information according to the wireless communication protocol.

13. An electrical assembly (1) comprising an electrical apparatus (3) provided with a terminal (4) for connection to an electric cable (7) and a control accessory (5) according to any of claims 1 to 12, the control accessory (5) comprising a frame (9) provided of a cooperation system (11) configured to cooperate with the electrical apparatus (3) in a mounted position.

14. A method for monitoring an electrical apparatus (3) by a control accessory (5) according to any of claims 1 to 12, the electrical apparatus (3) being provided with a connection terminal (4) connected to an electric cable (7), the monitoring method comprising the following steps of:
- (E mes I) measuring an electrical current flowing through the electric cable (7) and obtaining a measured value of the electrical current,
- (E comp I) comparing the measured value of the electrical current with an electrical current limit value,
- (E avert I) establishing a warning information of exceeding a limit value of the electrical current when the measured value of the electrical current is higher than the electrical current limit value.

15. The method for monitoring an electrical apparatus (3) according to claim 14, further comprising the following steps of:
- (E mes T) measuring a temperature at a determined location relative to the connection terminal (4) and obtaining a measured value of the temperature,
- (E comp T) comparing the measured value of the temperature with a temperature limit value,
- (E avert T) establishing a warning information of exceeding the temperature limit value when the measured value of the electrical current is higher than the electrical current limit value.
